# EUROPÄISCHE PATENTSCHRIFT

(11) **EP 2 869 674 B1**
(45) Veröffentlichungstag und Bekanntmachung des Hinweises auf die Patenterteilung: **10.02.2021**
(21) Anmeldenummer: 14003545.2
(22) Anmeldetag: 16.10.2014
(51) Int. Cl.: H05K 1/02, B29C 45/14, E05B 81/76, H05K 3/00

(54) **Kraftfahrzeugtürgriff mit einer Elektronikbaugruppe auf einer flexiblen Leiterplatte**
Vehicle door handle having an electronics assembly on a flexible circuit board
Poignée de porte de véhicule doté d'un bloc électronique sur une carte de circuits imprimés souple

(30) Priorität: 30.10.2013 DE 102013018204
(43) Veröffentlichungstag der Anmeldung: 06.05.2015
(73) Patentinhaber: Huf Hülsbeck & Fürst GmbH & Co. KG, 42551 Velbert (DE)
(72) Erfinder: Rhein, Michael, 41199 Mönchengladbach (DE); Bextermöller, Hubert, 45468 Mülheim an der Ruhr (DE)
(74) Vertreter: Patentanwaltskanzlei Methling

(56) Entgegenhaltungen:
- DE-A1-102008 062 516
- DE-A1-102009 009 729
- DE-B3-102004 038 569
- US-A- 5 903 440
- US-A1- 2007 281 499

## Beschreibung

Die Erfindung betrifft einen Kraftfahrzeugtürgriff mit einer Elektronikbaugruppe mit zumindest einer Leiterplatte, die Leiterbahnen aufweist und die mit Elektronikbauelementen bestückt ist.

Ferner betrifft die Erfindung ein Verfahren zur Herstellung eines Kraftfahrzeugtürgriffes mit einer Elektronikbaugruppe.

Aus der DE 10 2004 038 569 B3 ist ein Kraftfahrzeugtürgriff mit einem Greifbereich und einer im inneren des Greifbereichs angeordneten Elektronikbaugruppe bekannt, wobei sich im Inneren des Kraftfahrzeugtürgriffs ein Kunststoff-Spritzguß-Trägerkern erstreckt, die Elektronikbaugruppe in einer Ausnehmung des Trägerkerns angeordnet ist, und der Trägerkern zusammen mit der Elektronikbaugruppe mit einer eine Außenwandung des Kraftfahrzeugtürgriffs bildenden Abdeckschicht aus Kunststoff umspritzt ist. Derartige Elektronikbaugruppen zum Einbau in einen Kraftfahrzeugtürgriff sind bekannt. Beispielsweise werden derartige Elektronikbaugruppen mit kapazitiven Sensoren bestückt, die dazu dienen, als Annäherungselektronik zu arbeiten und das Ergreifen des Kraftfahrzeugtürgriffes durch einen Benutzer zu erkennen.

Aufgrund der Designanforderungen an Kraftfahrzeugtürgriffe sind derartige Türgriffe geschwungen ausgeführt, d.h. dass diese Türgriffe eine bogenförmige Grundform aufweisen. Aufgrund der bogenförmigen Ausgestaltung derartiger Kraftfahrzeugtürgriffe ist es bei einer aufwendigeren Elektronik, die mehrere verschiedene Funktionen erfüllen soll, erforderlich, mehrere einzelne Leiterplatten, die Leiterbahnen aufweisen und mit Elektronikbauelemente bestückt sind, in den Kraftfahrzeugtürgriff zu integrieren und jeweils mit einem Anschlussbereich zu versehen.

Nachteilig ist dabei, dass mehrere einzelne Leiterplatten mit jeweils einem Anschlussbereich in den Grundkörper des Kraftfahrzeugtürgriffes einzusetzen und anzuschließen sind, um die in den Kraftfahrzeugtürgriff integrierte Elektronikbaugruppe dem bogenförmigen Design des Kraftfahrzeugtürgriffes anpassen zu können.

Die Aufgabe der Erfindung ist es daher, eine Elektronikbaugruppe zum Einbau in einen Kraftfahrzeugtürgriff derart weiter zu bilden, dass es möglich ist, mehrere verschiedene Elektronikbauelemente auf einer einzelnen Leiterplatte anzuordnen, die an den jeweiligen Kraftfahrzeugtürgriff angepasst in den Grundkörper des Kraftfahrzeugtürgriffes eingesetzt werden kann, ohne dass es bei einer Verformung der Leiterplatte zu einer Beschädigung der Leiterbahnen oder der Elektronikbauteile kommt. Eine weitere Aufgabe der Erfindung ist es, ein Verfahren zur Herstellung eines Kraftfahrzeugtürgriffes mit einer Elektronikbaugruppe anzugeben, welches den Einbau einer einzelnen Leiterplatte mit den erforderlichen Elektronikbauelementen und eine einfache Fertigung ermöglicht.

Diese Aufgabe wird erfindungsgemäß durch einen Kraftfahrzeugtürgriff gemäß Anspruch 1 sowie ein Verfahren gemäß Anspruch 13 gelöst. Vorteilhafte Weiterbildungen der Erfindung sind in den Unteransprüchen angegeben.

Besonders vorteilhaft bei dem Kraftfahrzeugtürgriff mit einer Elektronikbaugruppe, mit zumindest einer Leiterplatte, die Leiterbahnen aufweist und mit Elektronikbauelementen bestückt ist, wobei die Leiterplatte zumindest einen Abschnitt mit einer Materialschwächung zur Ausbildung eines Biegebereiches aufweist, ist es, dass die Materialschwächung der Leiterplatte durch eine Materialabtragung, insbesondere eine Ausfräsung von mehr als der Hälfte, insbesondere mehr als zwei Dritteln der Dicke der Leiterplatte gebildet ist.

Kern der Erfindung ist es somit, dass die Leiterplatte der Elektronikbaugruppe zumindest einen Bereich mit einer definierten Materialschwächung aufweist, so dass dieser Bereich der Materialschwächung einen flexiblen Bereich der an sich unflexiblen Leiterplatte bildet. Zwar weist jede bekannte Leiterplatte eine gewisse Flexibilität und Biegsamkeit auf, jedoch sind herkömmliche Leiterplatten nicht dazu vorgesehen, an einer bestimmten Stelle gebogen zu werden, da dies zu einer Beschädigung der Leiterplatte und der darauf angeordneten Leiterbahnen führen würde. Eine herkömmliche aus Kunststoff bestehende Leiterplatte ist in einem gewissen Rahmen biegsam aufgrund der Materialeigenschaften des Leiterplattenmaterials, jedoch würde ein Biegen einer herkömmlichen Leiterplatte unweigerlich zu einem Bruch der Leiterplatte und zu einer Beschädigung der Leiterbahnen führen. Kern der Erfindung ist es daher, eine an sich nicht zur Ausbildung eines Biegebereiches vorgesehene Leiterplatte gezielt mit einer Materialschwächung durch eine Materialabtragung zu versehen, so dass in dem Abschnitt, der die gezielt eingebrachte Materialschwächung aufweist, ein Biegebereich ausgebildet wird, so dass eine Biegung um einen bestimmten Winkel möglich ist, ohne die auf der Leiterplatte angeordneten Leiterbahnen und Elektronikbauelemente zu beschädigen.

Hierdurch ist es möglich, derartige Elektronikbaugruppen so anzupassen, dass diese auch in einen bogenförmig ausgestalten Außentürgriff eines Kraftfahrzeuges eingebaut werden können und die erforderliche Elektronik für den Kraftfahrzeugtürgriff in diesen Türgriff integriert werden kann. Die Leiterplatte der Elektronikbaugruppe kann somit der Kontur des Kraftfahrzeugtürgriffes angepasst und optimal in den Türgriff eingepasst werden.

Dabei ist die Materialschwächung der Leiterplatte durch eine Materialabtragung, bei der es sich insbesondere um eine Ausfräsung handeln kann, von mehr als der Hälfte, insbesondere mehr als 2/3 der Dicke der Leiterplatte gebildet. Dies bedeutet, dass von dem Material der Leiterplatte, bei dem es sich üblicherweise um einen Kunststoff handelt, und die eine Dicke von wenigen Millimetern aufweist, in jenem Bereich der den Abschnitt mit der Materialschwächung zu Ausbildung eines Biegebereiches bildet, mehr als 50 %, insbesondere mehr als 2/3 des Materials zur Ausbildung der definierten Materialschwächung der Leiterplatte abgetragen werden.

Bevorzugt erfolgt die Materialabtragung durch Ausfräsen des Bereiches, der für die Materialschwächung vorgesehen ist. Alternativ ist auch jedes andere abtragende und/oder spanende Fertigungsverfahren einsetzbar.

Bei einer Leiterplatte mit einer Dicke von 2 mm können somit mehr als 1 mm respektive bis zu 1,5 mm oder 1,8 mm abgetragen werden.

Vorzugsweise beträgt die Dicke der Leiterplatte im Biegebereich aufgrund der Materialschwächung der Leiterplatte durch die Materialabtragung, insbesondere eine Ausfräsung weniger als 0,5 mm beträgt, insbesondere 0,3 mm.

Die nach Ausfräsung eines Biegebereiches verbleibende Materialstärke ist abhängig vom Leiterplattenbasismaterial. Bei dem vielfach als Leiterplattenbasismaterial verwendeten Glasfasergewebe mit einer Di/Tetra-Epoxy-Matrix, welches vielfach auch mit der Bezeichnung FR4 gekennzeichnet wird, verbleibt nach Einbringen der Ausfräsung in dem Biegebereich verbleibende Materialstärke von 0,3 mm.

Vorzugsweise erfolgt die Materialschwächung durch Materialabtragung, insbesondere Ausfräsung der Leiterplatte auf der den Leiterbahnen gegenüberliegenden Seite, so dass die Materialschwächung auf der Innenseite des Blegebereiches liegt. Mit dem Begriff der Innenseite des Biegebereiches ist dabei das Kurveninnere der Kurve, die durch die gebogene Leiterplatte in dem Biegebereich beschrieben wird, gemeint.

Durch die Materialabtragung wird die neutrale Faser in dem Material der Leiterplatte aus der Mitte der Leiterplatte nach Außen in Richtung der Seite der Leiterplatte verschoben, auf welcher die Leiterbahnen angeordnet sind. Hierdurch werden die Leiterbahnen bei einem Biegevorgang in dem Abschnitt der durch die Materialabtragung erzeugten Materialschwächung nur geringfügig gelängt und daher nicht beschädigt.

Die Leiterplatte kann mehrere Materialabtragungen insbesondere in Form von Ausfräsungen zur Ausbildung mehrerer Biegebereiche aufweisen. Dabei können die Ausfräsungen auf der selben Seite der Leiterplatte oder auf verschiedenen Seiten der Leiterplatte angeordnet sein. Sofern mehrere Materialabtragungen insbesondere Ausfräsungen auf der selben Seite der Leiterplatte angeordnet sind, bilden sich mehrere Biegebereiche aus mit identischer Orientierung der Krümmung. Bei Anordnung von Materialabtragungen insbesondere Ausfräsungen auf verschiedenen Seiten der Leiterplatte bilden sich mehrere Biegebereiche zur Verformung der Leiterplatte in unterschiedliche Krümmungsrichtung aus, so dass die Leiterplatte insbesondere S-förmig ausgebildet sein kann. Hierdurch wird eine hohe Flexibilität erreicht und es besteht die Möglichkeit, die Elektronikbaugruppe an beliebig geformte Kraftfahrzeugtürgriffe anzupassen und die Elektronikbaugruppe in diese Kraftfahrzeugtürgriffe einzusetzen.

Vorzugsweise weist die Leiterplatte zumindest eine Materialabtragung insbesondere eine Ausfräsung der Leiterplatte auf einer Länge von mindestens 2 mm insbesondere mindestens 3 mm auf.

Es hat sich gezeigt, dass eine derartige Ausfräsung von einer Lange von mindestens 3 mm ausreichend ist, um einen Biegebereich der Leiterplatte zu schaffen, der es gestattet, die Leiterplatte um einen Winkel von bis zu 30° aus ihrer Grundform herauszublegen.

Mit dem Begriff der Länge der Materialabtragung insbesondere Ausfräsung ist dabei jene Erstreckung der Materialabtragung gemeint, die in Längsrichtung der Leiterplatte verläuft. Senkrecht zur Länge der Leiterplatte erstreckt sich die Leiterplatte über ihre Breite. Die dritte Dimension der Leiterplatte wird mit ihrer Dicke angegeben.

Die Leiterplatte kann zumindest eine Materialabtragung insbesondere eine Ausfräsung der Leiterplatte auf einer Länge von bis zum 10 mm insbesondere bis zum 7 mm aufweisen.

Es hat sich gezeigt, dass Materialabtragungen Insbesondere Ausfräsungen mit einer Länge von bis zu sieben Millimetern respektive von bis zu 10 mm geeignet sind, die Leiterplatte um einen Winkel von bis zu 90° oder mehr aus ihrer Grundform heraus zu biegen, ohne die auf der Leiterplatte angeordneten Leiterbahnen oder Elektronikbaugruppen zu beschädigen.

Entscheidend für die Länge der Materialabtragung ist das Maß der Biegung, also der Winkel, um den herum die Leiterplatte aus ihrer Grundform heraus ausgelenkt werden soll. Je größer dieser Winkel ist, umso größer muss die Länge der Materialabtragung ausgeführt werden.

Vorzugsweise weist die Leiterplatte zumindest eine Materialabtragung insbesondere eine Ausfräsung auf, die sich über die gesamte Breite der Leiterplatte erstreckt. Mit der Breite ist jene Erstreckung der Leiterplatte senkrecht zu ihrer Längsrichtung gemeint, Die Materialabtragung insbesondere Ausfräsung kann sich somit über die gesamte Breite senkrecht zur Längserstreckung der Leiterplatte erstrecken. Dies ist besonders vorteilhaft zur Ausbildung eines gleichmäßigen Biegebereiches.

In dem Fall, dass die Materialabtragung sich senkrecht zur Längsrichtung der Leiterplatte über die gesamte Breite der Leiterplatte erstreckt, wird ein Biegebereich ausgebildet in der Gestalt, dass nach dem Biegen der Leiterplatte die Seitenkanten beider Bereiche der Leiterplatte vor und hinter der Biegung in der selben Ebene liegen Es besteht auch die Möglichkeit, dass sich die Materialabtragung insbesondere Ausfräsung unter einem von 90° abweichenden Winkel zur Längserstreckung der Leiterplatte über die gesamte Breite der Leiterplatte erstreckt was dazu führt, dass die Seitenkanten der Bereiche der Leiterplatte vor und hinter dem Biegebereich nach dem Biegen der Leiterplatte in unterschiedlichen Ebenen liegen, so dass die Elektronikbaugruppe an beliebige raumliche Gestaltungen des Kraftfahrzeugtürgriffes nicht nur in einer Ebene, sondern dreidimensional angepasst werden kann.

In einer besonders bevorzugten Ausführungsform weist die Elektronikbaugruppe einen ein- oder mehrteiligen Halter zur Fixierung der Leiterplatte auf. Ein derartiger Halter zur Fixierung der Leiterplatte dient der Vereinfachung des Einbaus der Elektronikbaugruppe in den als Hohlkörper ausgebildeten Grundkörper des Kraftfahrzeugtürgriffes, welcher die Elektronikbaugruppe aufnimmt, und fixiert und sichert die Leiterplatte innerhalb des Hohlraumes des Türgriffs.

Vorzugsweise weist die Elektronikbaugruppe einen derartigen ein- oder mehrteiligen Halter zur Fixierung der Leiterplatte auf, der zumindest einen Winkel im Biegebereich der Leiterplatte aufweist.

Der Winkel in dem Halter kann dabei insbesondere durch Zwischenstücke gebildet sein. Der Halter kann jedoch auch einstückig ausgebildet sein. Ferner kann der Halter ein Filmscharnier aufweisen, um das Zusammenbauen von Halter und Leiterplatte zu erleichtern,

Durch einen derartigen Halter mit zumindest einem Winkel ist es möglich, die gebogene Leiterplatte in einen solchen Halter einzusetzen und zu fixieren, um zu vermeiden, dass der Biegebereich der Leiterplatte versehentlich mehrfach aus seiner Grundform heraus ausgelenkt wird, um Beschädigungen an den auf der Leiterplatte angeordneten Leiterbahnen zu vermeiden. Der Winkel entspricht dabei der gewünschten Auslenkung der Leiterplatte aus der Grundform heraus.

Vorzugsweise sind dabei der Biegebereich der Leiterplatte und das Filmscharnier des Halters nicht fluchtend sondern versetzt zueinander angeordnet, sodass sich der Biegebereich und das Filmscharnier im montierten Zustand gegenseitig versteifen.

Vorzugsweise weist die Elektronikbaugruppe daher einen ein- oder mehrteiligen Halter zur Fixierung der Leiterplatte auf, der eine Biegelehre für die Leiterplatte bildet. Hierdurch ist es möglich, die Leiterplatte nur ein einziges Mal aus ihrer Grundform heraus zu verformen und sofort in den eine Biegelehre für die Leiterplatte bildenden Halter zur Fixierung der Leiterplatte einzusetzen.

Bevorzugt weist die Elektronikbaugruppe einen ein- oder mehrteiligen Halter zur Fixierung der Leiterplatte auf, wobei der Halter die Leiterplatte an einer ersten Seitenkante mit Rastnasen übergreift und die der ersten Seite gegenüberliegende Seitenkante der Leiterplatte an Schnapphaken an dem Halter eingerastet ist. Die Leiterplatte wird somit mit einer ersten Seitenkante hinter Rastnasen in den Halter zur Fixierung eingesetzt und dann in den Halter eingeschwenkt, so dass die der ersten Seitenkante der Leiterplatte gegenüberliegende Seitenkante der Leiterplatte von Schnapphaken des Halters übergriffen werden kann so dass die Schnapphaken einrasten und die Leiterplatte in dem Halter eingerastet und fixiert ist. Mit dem Begriff der Seitenkanten sind die in Längsrichtung der Leiterplatte verlaufenden Kanten der Leiterplatte gemeint.

Alternativ oder kumulativ zu derartigen Rastnasen und Schnapphaken können auch Bohrungen und/oder Durchbrüche in der Leiterplatte sowie dem Halter vorgesehen sein, die im montierten Zustand von Leiterplatte und Halter in einer Flucht liegen und von Befestigungsstiften durchgriffen werden. Alternativ können auch Bohrungen und/oder Durchbrüche in der Leiterplatte angeordnet sein, in die an dem Halter insbesondere einstückig angeordnete Befestigungsstifte eingreifen und hierdurch die Leiterplatte fixieren.

Bevorzugt erfolgt daher die Fertigung der Elektronikbaugruppe in der Weise, dass die Leiterplatte an den vorgesehenen Biegebereichen ausgefräst wird, um durch die Materialabtragung die Biegebereiche auszubilden. Dabei wird die in Längsrichtung der Leiterplatte vorgesehene Länge der Ausfräsung dem vorgesehenen Biegewinkel angepasst. Das bedeutet, dass je geringer die Abweichung von der Grundform ist, umso kürzer kann die Ausfräsung sein. Bei größeren Abweichungen aus der Grundform bis hin zu 90° oder mehr ist die Länge der Ausfräsung dementsprechend zu vergrößern. Nach Einbringen der Biegebereiche durch Materialabtragung der Leiterplatte wird diese bestückt und mit Hilfe des sowohl zur Fixierung als auch als Biegelehre dienenden Halters in die gewünschte Form verformt und anschließend in den als Hohlkörper ausgebildeten Kraftfahrzeugtürgriff eingesetzt. Dadurch dass der Halter der Leiterplatte gleichzeitig als Biegelehre verwendet wird, erfolgt die Biegung der Leiterplatte aus ihrer Grundform heraus an jedem Biegebereich nur ein einziges Mal, so dass die auf der Leiterplatte angeordneten Leiterbahnen nicht beschädigt werden.

Der Kraftfahrzeugtürgriff weist somit erfindungsgemäß eine derartige Elektronikbaugruppe auf. Ferner kann der Kraftfahrzeugtürgriff nach dem Einbau der Elektronikbaugruppe in den Türgriff mit wasserdicht aushärtendem Material ausgegossen werden. Mit dem Begriff des Aushärtens ist damit gemeint, dass das Material nach dem Aushärten nicht eine bestimmte Härte aufweisen muss, sondern lediglich, dass das Material nicht mehr fließt. So kann der Kraftfahrzeugtürgriff insbesondere mit einem Silikon oder dergleichen ausgegossen werden, welches die Elektronikbaugruppe in dem Türgriff wasserdicht umschließt, jedoch selbst eine gewisse Verformbarkeit aufweist.

Durch die erfindungsgemäße Elektronikbaugruppe ist es somit möglich, größere Bereiche eines bogenförmig ausgestalteten Kraftfahrzeugtürgriffes mit einer Leiterplatte auszufüllen, so dass die Elektronikbaugruppe verschiedene Elektronikbauteile aufweisen und damit verschiedene Funktionen erfüllen kann. So kann die Elektronikbaugruppe mit einem kapazitiven Sensor ausgerüstet sein, um die Annäherung der Hand eines Kraftfahrzeugbenutzers bei dem Versuch, die Kraftfahrzeugtür durch Bestätigung des Türgriffs zu öffnen, zu erkennen. Ferner kann die Elektronikbaugruppe einen Hallsensor aufweisen, der dazu dient zu erkennen, ob der Kraftfahrzeugtürgriff an der Kraftfahrzeugtür aus seiner Ruheposition heraus in die Öffnungsstellung gezogen ist. Ferner kann die Elektronikbaugruppe eine Antenne für eine Nahfeldkommunikation sowie die für eine solche Nahfeldkommunikation erforderlichen Elektronikbauelemente aufweisen.

Durch die Ausbildung eines oder mehrerer Biegebereiche an der Leiterplatte ist somit die Anpassung der Leiterplatte an die Kontur eines Kraftfahrzeugtürgriffes möglich, so dass größere Bereiche des bogenförmig ausgestalteten Kraftfahrzeugtürgriffes für die Integration der Elektronikbaugruppe genutzt werden können. Hierdurch können gegenüber den bekannten Kraftfahrzeugtürgriffen weitere zusätzliche Funktionen realisiert und die hierfür erforderlichen Elektronikbauteile in den Kraftfahrzeugtürgriff integriert werden. Besonders vorteilhaft bei dem Verfahren zur Herstellung eines Kraftfahrzeugtürgriffes mit einer Elektronikbaugruppe, ist es daher, dass dieses folgende Schritte aufweist:
- Bereitstellen eines Türgriffrohlings;
- Bereitstellen einer Leiterplatte zur Bestückung mit Elektronikbauelementen;
- Einbringen zumindest eines Abschnittes mit einer Materialschwächung durch Materialabtragung, insbesondere durch eine Ausfräsung der Leiterplatte, zur Ausbildung eines Biegebereiches in der Leiterplatte;
- Einsetzen der Leiterplatte in einen als Biegelehre dienenden Halter bei gleichzeitiger Verformung der Leiterplatte im Biegebereich, insbesondere Einsetzen der Leiterplatte in Rastnasen an dem Halter und Einrasten der Leiterplatte hinter Schnapphaken des Halters und/oder mittels in Bohrungen und/oder Ausnehmungen der Leiterplatte eingreifender Befestigungsstifte;
- Einsetzen des Halters mit Leiterplatte in den Türgriffrohling;
- Ausgießen des Türgriffrohlings mit wasserdicht aushärtendem Material.

Der Halter dient dabei zu einem der Verformung der Leiterplatte in die gewünschte Form sowie Fixierung der gebogenen Leiterplatte im gebogenen Zustand, um ein mehrfaches Verformen und die damit verbundene Gefahr von Beschädigungen der Leiterbahnen zu verhindern. Gleichzeitig verhindert der Halter ein Aufschwimmen der Leiterplatte beim Ausgießen des Türgriffrohlings mit wasserdicht aushärtendem Material, da der Halter die Leiterplatte in dem auszugießenden Hohlraum des Türgriffrohlings sichert.

Vorzugsweise wird die Leiterplatte vor oder nach dem Einbringen der Materialschwächung mit Elektronikbauelementen bestückt. Besonders bevorzugt erfolgt die Bestückung der Leiterplatte nach dem Erzeugen der Biegebereiche durch Einbringung der Materialschwächung durch Materialabtragung, insbesondere durch eine Ausfräsung der Leiterplatte. Es besteht jedoch auch die Möglichkeit, dass die Leiterplatte bereits vorher mit Elektronikbauelementen bestückt wird.

Bei dem Halter handelt es sich vorzugsweise um ein Kunststoffspritzgussteil.

Ein Ausführungsbeispiel der Erfindung ist in den Figuren dargestellt und wird nachfolgend näher erläutert. Es zeigen:
- Fig. 1: Eine Ansicht auf die Seitenkante einer Leiterplatte mit zwei Biegebreichen vor der Verformung;
- Fig. 2: die Unterseite der Leiterplatte nach Fig. 1;
- Fig. 3: die Ansicht auf die Seitenkante der Leiterplatte nach Fig. 1 nach der Verformung und dem Einsetzen in einen Halter.

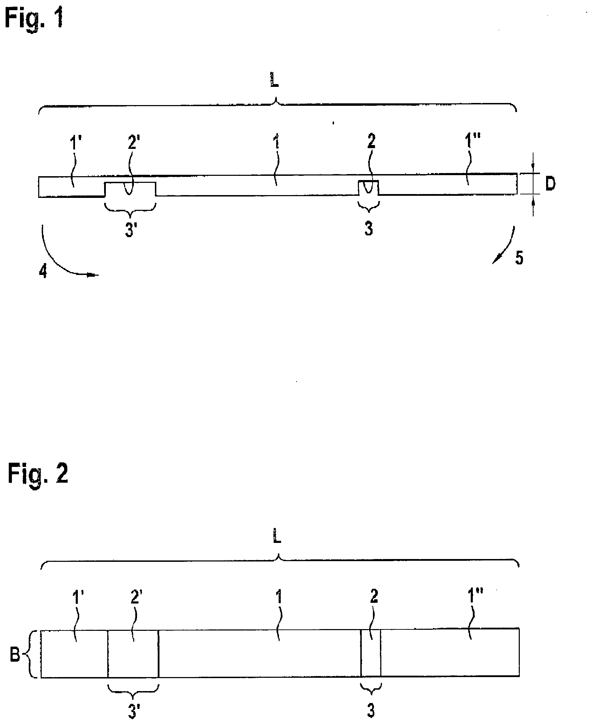

In den Figuren 1 und 2 ist die Leiterplatte einer erfindungsgemäßen Elektronikbaugruppe in zwei Ansichten dargestellt. Fig. 1 zeigt die Ansicht auf die Seitenkante der Leiteplatte und Fig. 2 zeigt die Unterseite der Leiterplatte nach Fig. 1.

Die Leiterplatte 1 weist die Länge L auf und die Breite B. Die Dritte Dimension der Leiterplatte 1 ist gebildet durch die Dicke D, wie dies in Fig. 1 erkennbar ist.

Die Leiterplatte 1 weist insgesamt 2 Ausfräsungen 2, 2' auf. Im Bereich der Ausfräsungen 2, 2' sind mehr als 2/3 des Materials der Dicke D der Leiterplatte 1 ausgefräst worden. Die verbleibende Dicke der Leiterplatte 1 im Bereich der Ausfräsungen 2, 2' beträgt 0,3 mm. Hierdurch werden die Biegebereiche 3, 3'. gebildet

Der rechte Bereich 1" der Leiterplatte 1 kann um den Biegebereich 3 herum entlang des Pfeiles 5 aus der in Fig. 1 dargestellten Ruhelage heraus verlagert werden, ohne die auf der Rückseite der Leiterplatte 1 angeordneten Leiterbahnen zu beschädigen. Der linke Bereich 1' der Leiterplatte 1 kann entsprechend des Pfeiles 4 um den Biegebereich 3' herum aus der in Fig. 1 dargestellten Ruhelage heraus verformt werden.

Da der linke Bereich 1' um einen Winkel von 90° aus der Ruhelage heraus verformt werden soll, beträgt die Länge der Ausnehmung 2' in der Leiterplatte 1 7 mm, d.h. dass die Länge des Biegebereiches 3' dementsprechend 7 mm beträgt. Mit der Länge des Biegebereiches 3' ist die Erstreckung der Ausfräsung 2' in Richtung der Längserstreckung L der Leiterplatte 1 gemeint.

Da der rechte Bereich 1" der Leiterplatte 1 in Richtung des Pfeiles 5 lediglich um einen Winkel von unter 30° aus der in Fig. 1 dargestellten Ruhelage heraus verformt werden soll, ist der Biegebereich 3 durch die Ausnehmung 2 entsprechend kleiner gestaltet, d.h. dass die Länge der Ausnehmung 2 in Längsrichtung L der Leiterplatte 1 nur ca. 3 mm beträgt. Die Figuren sind nicht maßstabsgerecht und dienen lediglich der Erläuterung.

in Fig. 2 ist die Unterseite der Leiterplatte 1 nach Fig. 1 dargestellt und man erkennt die beiden Dimensionen der Länge L und der Breite B der Leiterplatte 1. Ferner sind erkennbar die beiden Ausfräsungen 2, 2' zur Ausbildung der Biegebereiche 3, 3'.

Die Ausfräsungen 2, 2' sind senkrecht zu den Längskanten der Leiterplatte 1 ausgerichtet, sodass die Längskanten der Abschnitte 1', 1" der Leiterplatte auch nach dem Biegen der Abschnitte 1', 1" der Leiterplatte entlang der Pfeile 4, 5 aus der Ruhelage heraus in einer Ebene liegen.

In einer nicht dargestellten Alternative sind die Biegebereiche 3, 3' unter einem von 90° abweichenden Winkel zu den Seitenkanten der Leiterplatte 1 angeordnet, was dazu führt, dass einzelne Leiterplattenabschnitte 1, 1' durch das Biegen um die Biegbereiche 3, 3' herum aus der Ebene heraus wandern, d.h. dass die Seitenkanten der verschiedenen Leiterplattenabschnitte 1', 1, 1" nach der Verformung nicht mehr in einer Ebene liegen. Hierdurch lassen sich verschiedene dreidimensionale Formen der Leiterplatte zur Anpassung an dreidimensional ausgeformte Kraftfahrzeugtürgriffe erzeugen.

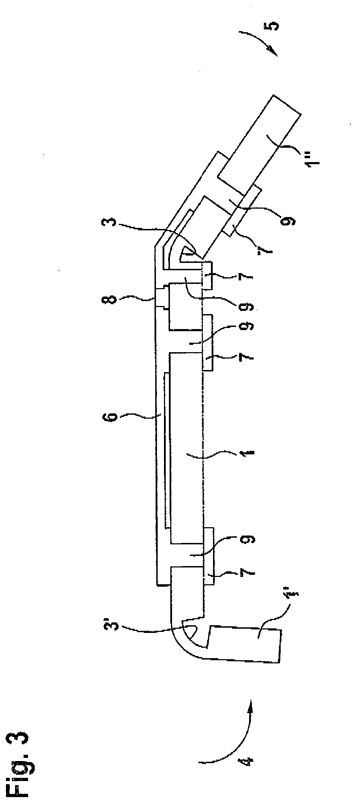

Fig. 3 zeigt die Ansicht auf die Seitenkante der Leiterplatte 1 nachdem die Leiterplatte 1 bestückt und in den die Leiterplatte 1 aufnehmenden Halter 6 eingesetzt worden ist. Dabei dient der Halter 6 gleichzeitig als Biegelehre für die Leiterplatte 1 und der Fixierung der Gesamtanordnung in einem in den Figuren nicht dargestellten, die Elektronikbaugruppe aufnehmenden Kraftfahrzeugtürgriff.

Wie in Fig. 3 erkennbar, ist der linke Bereich 1' der Leiterplatte 1 entlang des Pfeiles 4 um 90° aus der Ruhelage heraus um den Biegebereich 3' herum verformt worden.

Der rechte Bereich 1" der Leiterplatte 1 ist entlang des Pfeiles 5 um ca. 20° um den Biegebereich 3 herum aus seiner in Fig. 1 dargestellten Ruhelage heraus verformt worden.

Die Leiterplatte 1 wird dabei von dem Halter 6 fixiert. Hierzu ist die Leiterplatte 1 in Rastnasen 7 des Halters 6 eingesetzt worden. Diese Rastnasen 7 liegen in der Bildebene gemäß Fig. 3 hinter der Leiterplatte 1. In der Bildebene gemäß Fig. 3 vor der Leiterplatte 1 liegen die die Leiterplatte 1 übergreifenden Schnapphaken 9 des Halters 6, so dass die Leiterplatte 1 in dem Halter 6 gesichert und fixiert ist.

Korrespondierend zu dem Biegebereich 3 weist der Halter 6 einen abgewinkelten Abschnitt auf, so dass sowohl der Basisbereich 1 als auch der ausgelenkte Bereich 1" der Leiterplatte 1 von dem Halter 6 fixiert werden können. Um den abwinkelten Bereich des Halters 6 in diesem Bereich mit den Rastnasen 7 und den Schnapphaken 9 mit der abgewinkelten Leiterplatte 1 montieren zu können, weist der Halter 6 ein Filmscharnier 8 auf. Dieses Filmscharnier 8 ist in der Bildebene gemäß Figur 3 gegenüber dem Biegebereich 3 der Leiterplatte 1 versetzt angeordnet. Die Kontur des abgewinkelten Bereichs des Halters 6 entspricht der beabsichtigten Abwinkelung des ausgelenkten Bereichs 1" der Leiterplatte 1 in Richtung des Pfeiles 5. Unmittelbar neben dem Biegebereich 3 ist die Leiterplatte 1 von einer Rastnase 7 und einem Schnapphaken 9 des Halters 6 fixiert, um den Biegebereich 3 zu schützen und die Leiterplatte 1 in dem Halter 6 zu fixieren.

Um ein Einrasten des Leiterplatte 1 in den Rastnasen 7 und Schnapphaken 9 des Halters 6 zu ermöglichen, ist das Filmscharnier 8 in dem Halter 6 vorgesehen. Der abgewinkelte Bereich des Halters 6 wird hierzu um das Filmscharnier 8 herum aus der Ruhelage ausgelenkt und nach dem Einlegen der Leiterplatte 1 wieder in die Position gemäß Figur 3 zurückgeschwenkt, in welcher die Kontur des abgewinkelten Bereiches des Halters 6 dem Winkel der Leiterplatte 1 folgt. Bei der Montage von Halter 6 und Leiterplatte 1 werden dabei bei dem Zurückschwenken des Halters 6 um das Filmscharbier herum die Rastnase 7 und der Schnapphaken 9 des Halters 6 in Eingriff gebracht, die unmittelbar links neben dem Biegebereich 3 der Leiterplatte 1 liegen. Ferner kommen die Rastnase 7 und der Schnapphaken 9 an dem abgewinkelten Bereich 1" der Leiterplatte 1 in Eingriff und fixieren somit die abgewinkelte Leiterplatte 1 in dem Halter 6.

Dabei ist das Filmscharnier 8 des Halters 8 in Richtung der Längserstreckung von Leiterplatte 1 und Halter 6 in der Bildebene gemäß Figur 3 versetzt zu dem Biegebereich 3 in der Leiterplatte 1 angeordnet. Dieser Versatz zwischen dem Biegebereich 3 und dem Filmscharnier 8 bewirkt ein gegenseitige Hemmung von Leiterplatte 1 und Halter 6 im montierten Zustand, wie er in Figur 3 dargestellt ist. Durch diese gegenseitige Hemmung von Leiterplatte 1 und Halter 6 im montierten Zustand wird ein Zurückschwenken der gebogenen Leiterplatte 1 ebenso verhindert, wie ein Zurückschwenken des Halters 6. Der Halter 6 und die Leiterplatte 1 stützen sich gegenseitig aufgrund des Versatzes zwischen Biegebereich 3 und Filmscharnier 8.

Die in Fig. 3 dargestellte Elektronikbaugruppe mit Leiterplatte 1 und Halter 6 kann sodann in einen in den Figuren nicht dargestellten Kraftfahrzeugtürgriff eingesetzt werden. Abschließend wird der Holkörper des Kraftfahrzeugtürgriffes mit einem die Elektronikbaugruppe gegen Wasser schützenden aushärtendem Material ausgegossen.

Auf der Leiterplatte 1 ist angeordnet ein kapazitiver Sensor sowie weitere Elektronikbauteile zur Erkennung der Annäherung einer Hand eines Benutzers in der Griffmulde des Kraftfahrzeugtürgriffes. Diese Erkennung dient der Aktivierung einer Identifikationselektronik, die dazu dient, die Nutzungsberechtigung des Benutzers durch Nutzung einer Nahfeldkommunikation zu überprüfen.

Hierzu weist der rechte um den Biegebereich 3 herum ausgelenkte Bereich 1" der Leiterplatte 1 eine Antenne für eine Nahfeldkommunikation sowie die ferner zum Aufbau einer Nahfeldkommunikation erforderlichen Elektronikbauteile auf.

Der linke um 90° abgewinkelte Bereich 1' der Elektronikbaugruppe gemäß Fig. 3 weist einen Hallsensor auf, der dazu dient zu erkennen, ob der Türgriff aus seiner Ruhelage heraus am Kraftfahrzeug ausgelenkt wurde.

Dementsprechend können sämtliche in einen Kraftfahrzeugtürgriff zu integrierenden Elektronikbauteile auf der Leiterplatte 1 angeordnet werden und aufgrund der Ausfräsungen 2, 2' und der Ausbildung der Biegebereiche 3, 3' in der Leiterplatte 1 kann diese der Kontur des Kraftfahrzeugtürgriffes angepasst werden.

## Patentansprüche

1. Kraftfahrzeugtürgriff mit einer Elektronikbaugruppe, mit zumindest einer Leiterplatte (1), die Leiterbahnen aufweist und mit Elektronikbauelementen bestückt ist, **dadurch gekennzeichnet, dass** die Leiterplatte (1) zumindest einen Abschnitt mit einer Materialschwächung zur Ausbildung eines Biegebereiches (3, 3') aufweist, wobei die Materialschwächung der Leiterplatte durch eine Materialabtragung der Leiterplatte (1) gebildet ist, wobei die Elektronikbaugruppe einen ein- oder mehrteiligen Halter (6) zur Fixierung der Leiterplatte (1) aufweist, der eine Biegelehre für die Leiterplatte (1) bildet.

2. Kraftfahrzeugtürgriff nach Anspruch 1, **dadurch gekennzeichnet, dass** die Dicke der Leiterplatte im Biegebereich aufgrund der Materialschwächung der Leiterplatte durch die Materialabtragung, insbesondere eine Ausfräsung (2, 2') weniger als 0,5 mm beträgt, insbesondere 0,3 mm beträgt.

3. Kraftfahrzeugtürgriff nach Anspruch 1 oder 2, **dadurch gekennzeichnet, dass** die Materialschwächung durch Materialabtragung, insbesondere durch eine Ausfräsung (2, 2') der Leiterplatte (1) auf der den Leiterbahnen gegenüber liegenden Seite erzeugt ist, sodass die Materialschwächung auf der Innenseite des Biegebereiches (3, 3') liegt.

4. Kraftfahrzeugtürgriff nach einem der vorherigen Ansprüche, **dadurch gekennzeichnet, dass** die Leiterplatte (1) mehrere Materialabtragungen, insbesondere Ausfräsungen (2, 2') zur Ausbildung mehrerer Biegebereiche (3, 3') aufweist, wobei die Ausfräsungen (2, 2') auf derselben Seite der Leiterplatte (1) oder auf verschiedenen Seiten der Leiterplatte (1) angeordnet sind.

5. Kraftfahrzeugtürgriff nach einem der vorherigen Ansprüche, **dadurch gekennzeichnet, dass** die Leiterplatte (1) zumindest eine Materialabtragung, insbesondere eine Ausfräsung (2, 2') der Leiterplatte (1) auf einer Länge von mindestens 2 mm, insbesondere mindestens 3 mm aufweist.

6. Kraftfahrzeugtürgriff nach einem der vorherigen Ansprüche, **dadurch gekennzeichnet, dass** die Leiterplatte (1) zumindest eine Materialabtragung, insbesondere eine Ausfräsung (2, 2') der Leiterplatte (1) auf einer Länge von bis zu 10 mm, insbesondere bis zu 7 mm aufweist.

7. Kraftfahrzeugtürgriff nach einem der vorherigen Ansprüche, **dadurch gekennzeichnet, dass** die Leiterplatte (1) zumindest eine Materialabtragung, insbesondere eine Ausfräsung (2, 2'), über die gesamte Breite insbesondere senkrecht oder unter einem von 90° abweichenden Winkel zur Längserstreckung (L) der Leiterplatte (1) aufweist.

8. Kraftfahrzeugtürgriff nach einem der vorherigen Ansprüche, **dadurch gekennzeichnet, dass** die Elektronikbaugruppe einen ein- oder mehrteiligen Halter (6) zur Fixierung der Leiterplatte (1) aufweist.

9. Kraftfahrzeugtürgriff nach einem der vorherigen Ansprüche, **dadurch gekennzeichnet, dass** die Elektronikbaugruppe einen ein- oder mehrteiligen Halter (6) zur Fixierung der Leiterplatte (1) aufweist, der zumindest einen Winkel im Biegebereich (3) der Leiterplatte (1), insbesondere ein Filmscharnier (8) aufweist.

10. Kraftfahrzeugtürgriff nach einem der vorherigen Ansprüche, **dadurch gekennzeichnet, dass** die Elektronikbaugruppe einen ein- oder mehrteiligen Halter (6) zur Fixierung der Leiterplatte (1) aufweist, wobei der Halter (6) die Leiterplatte an einer ersten Seitenkante mit Rastnasen (7) übergreift und die der ersten Seite gegenüber liegender Seitenkante der Leiterplatte (1) an Schnapphaken (9) an dem Halter eingerastet ist.

11. Kraftfahrzeugtürgriff nach einem der vorherigen Ansprüche, **dadurch gekennzeichnet, dass** der Türgriff nach dem Einbau der Elektronikbaugruppe in den Türgriff mit wasserdicht aushärtendem Material ausgegossen wurde.

12. Kraftfahrzeugtürgriff nach einem der vorherigen Ansprüche, **dadurch gekennzeichnet, dass** die Materialschwächung der Leiterplatte durch eine Ausfräsung (2, 2') von mehr als der Hälfte, insbesondere mehr als zwei Dritteln der Dicke (D) der Leiterplatte (1) gebildet ist.

13. Verfahren zur Herstellung eines Kraftfahrzeugtürgriffes mit einer Elektronikbaugruppe, **gekennzeichnet durch** die Schritte:
• Bereitstellen eines Türgriffrohlings;
• Bereitstellen einer Leiterplatte (1) zur Bestückung mit Elektronikbauelementen;
• Einbringen zumindest eines Abschnittes mit einer Materialschwächung durch Materialabtragung, insbesondere durch eine Ausfräsung (2, 2') der Leiterplatte (1), zur Ausbildung eines Biegebereiches (3, 3') in der Leiterplatte (1);
• Einsetzen der Leiterplatte (1) in einen als Biegelehre dienenden Halter (6) bei gleichzeitiger Verformung der Leiterplatte (6) im Biegebereich (3, 3'), insbesondere Einsetzen der Leiterplatte (1) in Rastnasen (7) und Einrasten der Leiterplatte (1) hinter Schnapphaken (9) des Halters (6) und/oder mittels in Bohrungen und/oder Ausnehmungen der Leiterplatte eingreifender Befestigungsstifte des Halters (6);
• Einsetzen des Halters (6) mit Leiterplatte (1) in den Türgriffrohling;
• Ausgießen des Türgriffrohlings mit wasserdicht aushärtendem Material.

14. Verfahren nach Anspruch 13, **dadurch gekennzeichnet, dass** die Leiterplatte (1) vor oder nach dem Einbringen der Materialschwächung mit Elektronikbauelementen bestückt wird.

## Claims

1. Vehicle door handle with an electronic module, having at least one circuit board (1), which has conductor tracks and is fitted with electronic units, **characterised in that** the circuit board (1) has at least one section with a material weakening for forming a bending area (3, 3'), wherein the material weakening of the circuit board is formed by a material abrasion of the circuit board (1), wherein the electronic module has a one-piece or multi-piece holder (6) for fixing the circuit board (1) which forms a bending gauge for the circuit board (1).

2. Vehicle door handle according to claim 1, **characterised in that** the thickness of the circuit board in the bending area due to the material weakening of the circuit board by material abrasion, in particular a milling groove (2, 2'), is less than 0.5 mm, in particular 0.3 mm.

3. Vehicle door handle according to claim 1 or 2, **characterised in that** the material weakening is formed by material abrasion, in particular by a milling groove (2, 2') of the circuit board (1) on the side opposite the conductor tracks, so that the material weakening is on the inside of the bending area (3, 3').

4. Vehicle door handle according to any of the preceding claims, **characterised in that** the circuit board (1) has a plurality of material abrasions, in particular milling grooves (2, 2') for forming a plurality of bending areas (3, 3'), wherein the milling grooves (2, 2') are arranged on the same side of the circuit board (1) or on different sides of the circuit board (1).

5. Vehicle door handle according to any of the preceding claims, **characterised in that** the circuit board (1) has at least one material abrasion, in particular a milling groove (2, 2') of the circuit board (1) on a length of at least 2 mm, in particular at least 3 mm.

6. Vehicle door handle according to any of the preceding claims, **characterised in that** the circuit board (1) has at least one material abrasion, in particular a milling groove (2, 2') of the circuit board (1) on a length of up to 10 mm, in particular up to 7 mm.

7. Vehicle door handle according to any of the preceding claims, **characterised in that** the circuit board (1) has at least one material abrasion, in particular a milling groove (2, 2'), over the entire width, in particular perpendicular to or at an angle other than 90° to the longitudinal extension (L) of the circuit board (1).

8. Vehicle door handle according to any of the preceding claims, **characterised in that** the electronic module has a one-piece or multi-piece holder (6) for fixing the circuit board (1).

9. Vehicle door handle according to any of the preceding claims, **characterised in that** the electronic module has a one-piece or multi-piece holder (6) for fixing the circuit board (1), which has at least one angle in the bending area (3) of the circuit board (1), in particular a film hinge (8).

10. Vehicle door handle according to any of the preceding claims, **characterised in that** the electronic module has a one-piece or multi-piece holder (6) for fixing the circuit board (1), wherein the holder (6) grips over the circuit board on a first side edge with latches (7) and the side edge of the circuit board (1) opposite the first side is engaged with snap-fits (9) onto the holder.

11. Vehicle door handle according to any of the preceding claims, **characterised in that** the door handle after the installation of the electronic module into the door handle was cast with watertight hardening material.

12. Vehicle door handle according to any of the preceding claims, **characterised in that** the material weakening of the circuit board by a milling groove (2, 2') is formed by more than half, in particular more than two thirds of the thickness (D) of the circuit board (1).

13. Method for producing a vehicle door handle with an electronic module, **characterised by** the steps:
• providing a door handle blank;
• providing a circuit board (1) for fitting with electronic units;
• introducing at least one section with a material weakening by material abrasion, in particular by a milling groove (2, 2') of the circuit board (1), for forming a bending area (3, 3') in the circuit board (1);
• inserting the circuit board (1) into a holder (6) used as a bending gauge at the same time as deforming the circuit board (6) in the bending area (3, 3'), in particular inserting the circuit board (1) into latches (7) and engaging the circuit board (1) behind snap-fits (9) of the holder (6) and/or by means of securing pins of the holder (6) engaging in bores and/or recesses of the circuit board;
• inserting the holder (6) with circuit board (1) into the door handle blank;
• casting the door handle blank with watertight hardening material.

14. Method according to claim 13, **characterised in that** the circuit board (1) is fitted with electronic units before or after introducing the material weakening.

## Revendications

1. Poignée de porte de véhicule automobile avec un module électronique, avec au moins une carte de circuit imprimé (1), qui présente des pistes conductrices et est équipée de composants électroniques, **caractérisée en ce que** la carte de circuit imprimé (1) présente au moins une section avec un affaiblissement de matière pour former une zone de cintrage (3, 3'), selon laquelle l'affaiblissement de matière de la carte de circuit imprimé est formé par un enlèvement de matière de la carte de circuit imprimé (1), selon laquelle le module électronique présente un support (6) en une ou plusieurs parties pour la fixation de la carte de circuit imprimé (1), qui forme un gabarit de cintrage pour la carte de circuit imprimé (1).

2. Poignée de porte de véhicule automobile selon la revendication 1, **caractérisée en ce que** l'épaisseur de la carte de circuit imprimé dans la zone de cintrage, en raison de l'affaiblissement de matière de la carte de circuit imprimé par l'enlèvement de matière, se chiffre en particulier à une fraisure (2, 2') inférieure à 0,5 mm, se chiffre en particulier à 0,3 mm.

3. Poignée de porte de véhicule automobile selon la revendication 1 ou 2, **caractérisée en ce que** l'affaiblissement de matière par enlèvement de matière, en particulier par une fraisure (2, 2') de la carte de circuit imprimé (1), est réalisé sur la face située à l'opposé des pistes conductrices, de façon que l'affaiblissement de matière se trouve sur la face intérieure de la zone de cintrage (3, 3').

4. Poignée de porte de véhicule automobile selon l'une des revendications précédentes, **caractérisée en ce que** la carte de circuit imprimé (1) présente plusieurs enlèvements de matière, en particulier des fraisures (2, 2') pour former plusieurs zones de cintrage (3, 3'), selon laquelle les fraisures (2, 2') sont disposées du même côté de la carte de circuit imprimé (1) ou sur différents côtés de la carte de circuit imprimé (1).

5. Poignée de porte de véhicule automobile selon l'une des revendications précédentes, **caractérisée en ce que** la carte de circuit imprimé (1) présente au moins un enlèvement de matière, en particulier une fraisure (2, 2') de la carte de circuit imprimé (1) sur une longueur d'au moins 2 mm, en particulier d'au moins 3 mm.

6. Poignée de porte de véhicule automobile selon l'une des revendications précédentes, **caractérisée en ce que** la carte de circuit imprimé (1) présente au moins un enlèvement de matière, en particulier une fraisure (2, 2') de la carte de circuit imprimé (1) sur une longueur pouvant aller jusqu'à 10 mm, en particulier 7 mm.

7. Poignée de porte de véhicule automobile selon l'une des revendications précédentes, **caractérisée en ce que** la carte de circuit imprimé (1) présente au moins un enlèvement de matière, en particulier une fraisure (2, 2'), sur toute la largeur, en particulier perpendiculairement à ou selon un angle s'écartant de 90° de l'étendue longitudinale (L) de la carte de circuit imprimé (1).

8. Poignée de porte de véhicule automobile selon l'une des revendications précédentes, **caractérisée en ce que** le module électronique présente un support (6) en une ou plusieurs parties pour la fixation de la carte de circuit imprimé (1).

9. Poignée de porte de véhicule automobile selon l'une des revendications précédentes, **caractérisée en ce que** le module électronique présente un support (6) en une ou plusieurs parties pour la fixation de la carte de circuit imprimé (1), qui présente au moins un angle dans la zone de cintrage (3) de la carte de circuit imprimé (1), en particulier une charnière à film (8).

10. Poignée de porte de véhicule automobile selon l'une des revendications précédentes, **caractérisée en ce que** le module électronique présente un support (6) en une ou plusieurs parties pour la fixation de la carte de circuit imprimé (1), selon laquelle le support (6) déborde de la plaque de circuit imprimé sur une première face latérale avec des nez d'encliquetage (7) et la face latérale de la carte de circuit imprimé (1) située à l'opposé de la première face est encliquetée avec des crochets d'encliquetage (9) sur le support.

11. Poignée de porte de véhicule automobile selon l'une des revendications précédentes, **caractérisée en ce que** la poignée de porte a été scellée après le montage du module électronique dans la poignée de porte avec une matière durcissable étanche à l'eau.

12. Poignée de porte de véhicule automobile selon l'une des revendications précédentes, **caractérisée en ce que** l'affaiblissement de matière de la carte de circuit imprimé est formé par une fraisure (2, 2') de plus de la moitié, en particulier de plus des deux tiers de l'épaisseur (D) de la carte de circuit imprimé (1).

13. Procédé de fabrication d'une poignée de porte de véhicule automobile avec un module électronique, **caractérisé par** les étapes :
- de préparation d'un flan de poignée de porte ;
- de préparation d'une carte de circuit imprimé (1) pour l'équiper de composants électroniques ;
- de mise en place d'au moins une section avec un affaiblissement de matière par enlèvement de matière, en particulier par une fraisure (2, 2') de la carte de circuit imprimé (1), pour former une zone de cintrage (3, 3') dans la carte de circuit imprimé (1) ;
- d'introduction de la plaque de circuit imprimé (1) dans un support (6) servant de gabarit de cintrage lors d'une déformation simultanée de la carte de circuit imprimé (6) dans la zone de cintrage (3, 3'), en particulier d'introduction de la plaque de circuit imprimé (1) dans des nez d'encliquetage (7) et d'encliquetage de la carte de circuit imprimé (1) derrière des crochets d'encliquetage (9) du support (6) et/ou au moyen de broches de fixation du support (6) s'insérant dans des alésages et/ou des creux de la carte de circuit imprimé ;
- d'introduction du support (6) avec la carte de circuit imprimé (1) dans le flan de poignée de porte ;
- de scellage du flan de poignée de porte avec une matière durcissable étanche à l'eau.

14. Procédé selon la revendication 13, **caractérisé en ce que** la carte de circuit imprimé (1) est équipée de composants électroniques avant ou après la mise en place de l'affaiblissement de matière.
